(19) Europäisches Patentamt
European Patent Office
Office européen des brevets

(11) **EP 1 685 650 B1**

(12) **EUROPÄISCHE PATENTSCHRIFT**

(45) Veröffentlichungstag und Bekanntmachung des Hinweises auf die Patenterteilung:
**17.01.2007 Patentblatt 2007/03**

(21) Anmeldenummer: 04797834.1

(22) Anmeldetag: **11.11.2004**

(51) Int Cl.:
**H03H 17/02** (2006.01)   **G01R 23/173** (2006.01)

(86) Internationale Anmeldenummer:
**PCT/EP2004/012809**

(87) Internationale Veröffentlichungsnummer:
**WO 2005/050841 (02.06.2005 Gazette 2005/22)**

(54) **SPEKTRUMANALYSATOR MIT ÜBER EINEN PHASEN-VARIATIONSPARAMETER EINSTELLBAREM AUFLÖSUNGSFILTER**

SPECTRUM ANALYZER HAVING A RESOLUTION FILTER THAT CAN BE ADJUSTED VIA A PHASE-VARIATION PARAMETER

ANALYSEUR DE SPECTRE DOTE D'UN FILTRE DE RESOLUTION REGLABLE PAR UN PARAMETRE DE VARIATION DE PHASE

(84) Benannte Vertragsstaaten:
**DE FR GB**

(30) Priorität: **19.11.2003 DE 10353958**

(43) Veröffentlichungstag der Anmeldung:
**02.08.2006 Patentblatt 2006/31**

(73) Patentinhaber: **Rohde & Schwarz GmbH & Co. KG 81671 München (DE)**

(72) Erfinder: **SCHMIDT, Kurt 85567 Grafing (DE)**

(74) Vertreter: **Körfer, Thomas Mitscherlich & Partner Patent- und Rechtsanwälte Sonnenstrasse 33 80331 München (DE)**

(56) Entgegenhaltungen:
DE-A1- 10 105 258       US-A- 2003 146 743
US-B1- 6 275 020        US-B1- 6 445 327

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 685 650 B1

## Beschreibung

Die Erfindung betrifft ein Auflösungsfilter (Resolution-Filter) für einen Spektrumanalysator.

Bei der Spektrumanalyse wird ein vorgegebener Frequenzbereich mit einem Auflösungsfilter (Resolution-Filter) mit einer vorgegebenen Bandbreite durchfahren (gesweept). Das Auflösungsfilter wird deshalb auch als Sweep-Filter bezeichnet. Ein solches Auflösungsfilter für einen Spektrumanalysator in analoger Bauweise ist beispielsweise aus der US 5,736,845 bekannt. Bei Auflösungsfiltern in bekannter analoger Bauweise kann nur eine begrenzte Sweepgeschwindigkeit erreicht werden, wobei der sogenannte K-Faktor, der angibt, wie schnell gesweept wird, bei Auflösungsfiltern in bekannter Bauweise beschränkt ist.

Es wurde bisher allgemein davon ausgegangen, daß man bei der Spektrumanalyse innerhalb von $T_{res}$ in der Größenordnung um $1/B_{res} = T_{res}$ sweepen darf, damit das Resolution-Filter noch einschwingen kann. Allerdings ist diese Aussage nur dann richtig, wenn von einem festen Filter für alle Sweepgeschwindigkeiten ausgegangen wird.

US 6,275,020 B1 und US 2003/0146743 A1 beschreiben Auflösungsfilter für hohe Sweepgeschwindigkeiten.

Ein digitales Auflösungsfilter für einen Spektrumanalysator ist aus der DE 101 05 258 A1 bekannt. Das dort beschriebene Auflösungsfilter ist durch eine gaußförmige Impulsantwort gekennzeichnet. Es handelt sich um ein sog. linearphasiges Auflösungsfilter. Linearphasige Filter haben eine relativ lange Gruppenlaufzeitverzögerung. Dadurch haben diese Filter beim Sweepen einen nicht unerheblichen Frequenznachlauf und die Mitte des Spektrums liegt nicht mehr im Frequenz-Ursprung. Ein Design-Freiheitsgrad, der eine Kompensation dieser unerwünschten Effekte ermöglichen würde, ist bei der in der DE 101 05 258 A1 definierten Impulsantwort des Auflösungsfilters nicht vorhanden.

Der Erfindung liegt deshalb die Aufgabe zugrunde, einen Spektrumanalysator bzw. ein Auflösungsfilter hierfür zu schaffen, wobei die Impulsantwort des Auflösungsfilters einen freien Design-Parameter hat, der die Kompensation des Frequenznachlaufs, der Verschiebung des Frequenz-Ursprungs und anderer unerwünschter Effekte ermöglicht.

Die Aufgabe wird bezüglich des Auflösungsfilters durch die Merkmale des Anspruchs 1 und bezüglich des Spektrum-analysators durch die Merkmale des Anspruchs 7 gelöst.

Es wird in den Phasen-Faktor der Impulsantwort der freie Variationsparameter $k_o$ eingeführt. Dieser freie Variationsparameter stellt einen Freiheitsgrad der Phase beim Design des Filters dar. Auf diese Weise können beispielsweise nicht nur linearphasige, sondern auch minimalphasige Filter effizient realisiert werden.

Die Unteransprüche betreffen vorteilhafte Weiterbildungen der Erfindung.

Der freie Variationsparameter $k_0$ wird so eingestellt, daß der durch die Gruppenlaufzeit des Auflösungsfilters bedingte Frequenznachlauf kompensiert wird.

Gleichzeitig kann der Variationsparameter $k_0$ auch so eingestellt werden, daß die Mitte des Frequenzgangs des Auflösungsfilters im Frequenz-Ursprung, also bei der Frequenz f=0 liegt.

Die Erfindung wird nachfolgend unter Bezugnahme auf die Zeichnung näher erläutert. In der Zeichnung zeigen:

Fig. 1    ein Blockschaltbild eines Spektrumanalysators, bei welchem das erfindungsgemäße Auflösungsfilter zum Einsatz kommen kann;

Fig. 2    ein Blockschaltbild der Spektrumanalyse im äquivalenten Basisband;

Fig. 3    die Impulsantwort eines linearphasigen Filters und eines minimalphasigen Gaußfilters;

Fig. 4    einen Sweep mit einem minimalphasigen Filter und

Fig. 5    einen Sweep mit einem linearphasigen Filter.

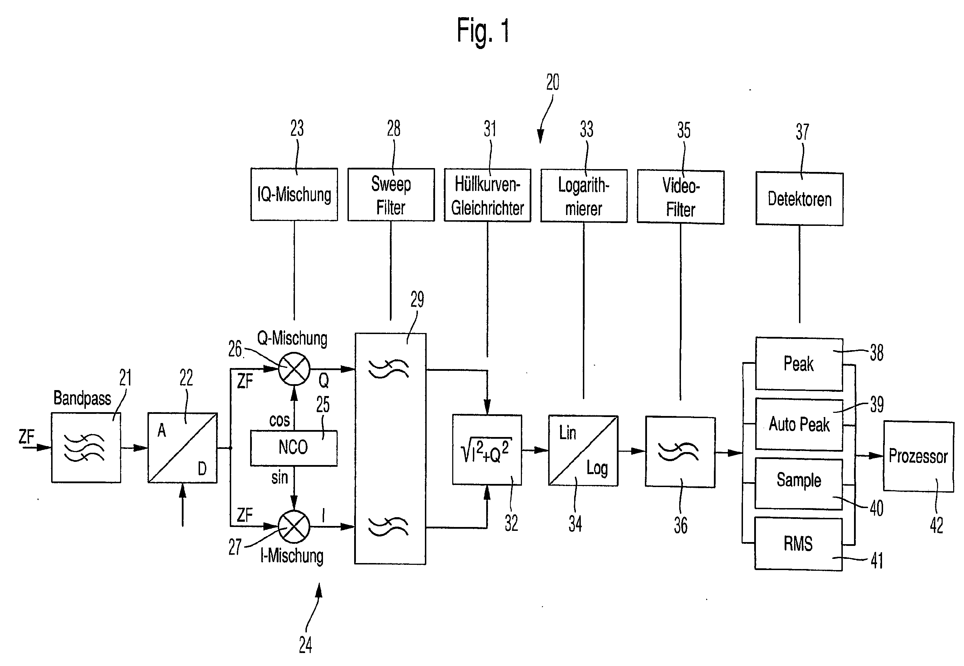

Fig. 1 zeigt einen Spektrumanalysator 20, bei welchem das erfindungsgemäße Auflösungsfilter 29 zum Einsatz kommt, im Überblick. In Fig. 1 ist nur der hier interessierende Signalbereich unterhalb der Zwischenfrequenz-Stufe dargestellt.

Das mit ZF bezeichnete Zwischenfrequenzsignal wird in einem Bandpaß 21 gefiltert. An den Bandpaß 21 schließt sich ein Analog/Digital-Wandler 22 an. Anschließend folgt die I/Q-Mischung 23 in einem I/Q-Demodulator 24, der in üblicher Weise aus einem lokalen Oszillator 25 mit zwei um 90° phasenverschobenen Ausgängen besteht, die zusammen mit den gefilterten und analog/digital-gewandelten Zwischenfrequenz-Signalen jeweils einem Mischer 27 des I -Zweigs und einem Mischer 26 des Q-Zweigs zugeführt werden.

Daran schließt sich die digitale Filterung 28 mit dem erfindungsgemäßen Auflösungsfilter 29 an. Schließlich erfolgt die Hüllkurven-Gleichrichtung 31 in einem Hüllkurven-Gleichrichter 32. Die Logarithmierung 33 erfolgt in einem Logarithmierer 34. Auf den Logarithmierer 34 folgt ein Videofilter 36, in welchem die Videofilterung 35 erfolgt.

Für die Detektion 37 können unterschiedliche Detektoren 38 bis 41, beispielsweise ein Peak-Detektor 38, ein Auto-Peak-Detektor 39, ein Sample-Detektor 40 und ein RMS (Route Mean Square)-Detektor zur Verfügung stehen.

Je nach Anforderungen können entweder alle vier Detektoren bei einem Spektrumanalysator 20 mit hoher Performance eingebaut werden, oder es können nur bestimmte Detektoren, z.B. bei spezialisierten Meßaufgaben nur ein einziger Detektor, eingebaut werden. Die Auswertung und Steuerung erfolgt über einen Mikroprozessor 42.

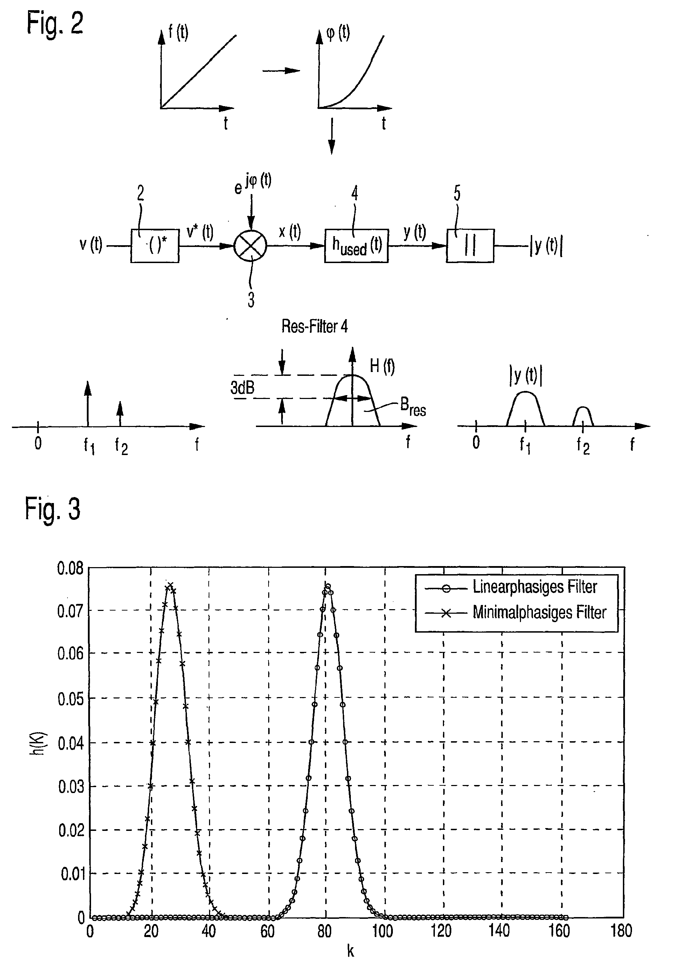

Fig. 2 zeigt ein vereinfachtes Blockschaltbild der Blöcke 24, 29 und 32 des Spektrumanalysators 20 aus Fig. 1. Das zu analysierende komplexe Eingangssignal v(t) wird einem Konjugiertkomplex-Bilder 2 zugeführt, der das konjugiertkomplexe Signal v*(t) des Eingangssignals v(t) bildet. In einem Mischer 3 wird das konjugiertkomplexe Eingangssignal v*(t) durch Multiplikation mit dem Sweep-Signal $e^{j\varphi(t)}$ in das Basisbandsignal x(t) heruntergemischt. In Fig. 2 ist oben die Frequenz f(t) des Sweep-Signals als Funktion der Zeit t dargestellt, wobei zu erkennen ist, daß sich die Sweep-Frequenz f(t) linear mit der Zeit t verändert. Durch Integration erhält man den Phasenwinkel $\varphi(t)$ als Funktion der Zeit t. Das Basisband-Signal x(t) wird dem erfindungsgemäßen Auflösungsfilter (im folgenden Resolution-Filter) 4 zugeführt. In dem Resolution-Filter 4 wird das Basisband-Signal x(t) mit der Impulsantwort $h_{used}(t)$ des Resolution-Filters 4 gefaltet. Dabei entsteht das Ausgangssignal y(t). In einem Betragsbildner 5 wird der Betrag |y(t)| des Signals y(t) gebildet.

Im unteren Bereich von Fig. 2 ist beispielhaft ein Eingangssignal v(t) dargestellt, dessen Spektrum aus zwei diskreten Spektrallinien besteht. Ferner ist ein Beispiel für die Übertragungsfunktion H(t) des Resolution-Filters 4 angegeben. Am Ausgang des Spektrum-Analysators 1 wird das rechts daneben dargestellte Spektrum angezeigt, wobei die Spektrallinien um die Auflösungsbandbreite $B_{res}$ des Resolution-Filters 4 verbreitert sind. Die Auflösungsbandbreite $B_{res}$ entspricht der Bandbreite bei einer Dämpfung um -3dB gegenüber dem Maximum.

Zum besseren Verständnis der Erfindung werden nachstehend die Überlegungen aus der DE 101 05 258 A1, welche zu einem Auflösungsfilter (Resolution-Filter) mit einer bestimmten Impulsantwort führen, nochmals kurz diskutiert.

Das Spektrum des Signals v(t) wird zuerst mit der Impulsantwort des Resolution-Filters gefenstert und anschließend gemäß

$$S(f) \; = \; \int_{-\infty}^{\infty} v(\tau)\, h_{res}(\tau)\cdot e^{-j\omega\tau}\, d\tau \;\; = \; H_{res}(f) \; * \; V(f)$$

$$(1)$$

die Fouriertransformation durchgeführt.

Interessant ist die Frage der Korrelation des Spektrums bei weißem Rauschen. Durch die Korrelation wird beschrieben, in welchem Abstand das Spektrum unkorreliert wird. Die AKF (Autokorrelationsfunktion) des Eingangssignals wird bei weißem Rauschen durch

$$E\left\{v(\tau)\, v^{*}(\tau+dt)\right\} = \underset{\text{real/imag}}{\underbrace{2}} \cdot N_0/2 \;\; \delta(dt)$$

$$(2)$$

beschrieben. Die AKF des Fourierspektrums ergibt sich unter Verwendung von Gleichung (1)

$$E\left\{S^{*}(f)\cdot S(f+df)\right\} = E\left\{\int_{-\infty}^{\infty} v^{*}(\tau_1)\, h_{res}^{*}(\tau_1)\cdot e^{j\omega\tau_1}\, d\tau_1 \cdot \int_{-\infty}^{\infty} v(\tau_2)\, h_{res}(\tau_2)\cdot e^{-j(\omega+d\omega)\tau_2}\, d\tau_2\right\}$$

$$= \int_{-\infty}^{\infty}\int_{-\infty}^{\infty} E\left\{v^{*}(\tau_1)\cdot v(\tau_2)\right\} h_{res}^{*}(\tau_1)\cdot h_{res}(\tau_2) e^{-j\omega(\tau_1-\tau_2)} e^{-jd\omega\tau_2}\, d\tau_1 d\tau_2$$

Durch Einsetzen von Gleichung (2) ergibt sich mit $\tau_1 = \tau_2 := \tau$

$$E\left\{S^*(f) \cdot S(f + df)\right\} = \int_{-\infty}^{\infty} N_0\, h_{res}^*(\tau) \cdot h_{res}(\tau)\, e^{-j\,d\omega\,\tau}\, d\tau$$

$$= N_0 \int_{-\infty}^{\infty} \left|h_{res}(\tau)\right|^2 \cdot e^{-j\,d\omega\,\tau}\, d\tau$$

$$= N_0 \cdot F\left\{\left|h_{res}(\tau)\right|^2\right\}$$

Für ein Gaußfilter gilt:

$$h_{gauss}(t) = \sqrt{\frac{\pi}{2\ln(2)}}\, B_{res} \cdot e^{-\frac{\pi^2}{2\ln(2)} \cdot \left(\frac{t}{T_{res}}\right)^2}$$

$$H_{gauss}(f) = e^{-2\ln(2) \cdot \left(\frac{f}{B_{res}}\right)^2}$$

$$(3)$$

Mit Gleichung (3) folgt:

$$R_h(\tau) = F^{-1}\left\{\left|H_{gauss}(f)\right|^2\right\}$$

$$= F^{-1}\left\{ e^{-2\ln(2) \cdot 2 \cdot \left(\frac{f}{B_{res}}\right)^2} \right\} \qquad \text{mit } B'_{res} = B_{res}/\sqrt{2}$$

$$= \sqrt{\frac{\pi}{2\ln(2)}} \cdot B'_{res} \cdot e^{-\frac{\pi^2}{2\ln(2)} \cdot \left(\frac{\tau}{T'_{res}}\right)^2} \qquad \text{mit } T'_{res} = T_{res}\sqrt{2}$$

$$= \underbrace{\sqrt{\frac{\pi}{2\ln(2)}} \cdot B_{res}/\sqrt{2}}_{:= B_{rausch}} \cdot e^{-\frac{\pi^2}{2\ln(2)} \cdot \left(\frac{\tau}{\sqrt{2} \cdot T_{res}}\right)^2}$$

$$(4)$$

Weiterhin folgt mit Gleichung (4)

$$F\left\{\left|h_{gauss}(t)\right|^2\right\} = F\left\{\frac{\pi}{2\ln(2)}B_{res}^2\; e^{-\frac{\pi^2}{2\ln(2)}\cdot 2\left(\frac{t}{T_{res}}\right)^2}\right\} \quad \text{mit } T_{res}' = T_{res}/\sqrt{2}$$

$$= \frac{\frac{\pi}{2\ln(2)}B_{res}^2}{\left(\frac{\pi}{2\ln(2)}\right)^{1/2}B_{res}'}\cdot e^{-2\ln(2)\cdot\left(\frac{f}{B_{res}'}\right)^2} \quad \text{mit } B_{res}' = B_{res}\sqrt{2}$$

$$= \underbrace{\sqrt{\frac{\pi}{2\ln(2)}}\,B_{res}\Big/\sqrt{2}}_{B_{rausch}}\cdot e^{-\ln(2)\cdot\left(\frac{f}{B_{res}}\right)^2}$$

$$(5)$$

Beim gaußschen Resolution-Filter erhält man mit Gleichung (5) :

$$\mathrm{E}\left\{S^*(f)\cdot S(f+df)\right\} = N_0\;\cdot B_{rausch}\cdot e^{-\ln(2)\cdot\left(\frac{df}{B_{res}}\right)^2}$$

$$(6)$$

In Fig. 2 ist das Blockschaltbild der Spektrumanalyse im äquivalenten Basisband gezeigt. Man beachte, daß das zu untersuchende HF-Signal $v(t)$ zwecks einfacherem Modell im äquivalenten Basisband betrachtet wird (d.h. keine Spektralanteile bei $f < 0$). Nach Bildung von $v^*(t)$ wird mit dem Drehzeiger $e^{j\varphi(t)}$ multipliziert und es entsteht

$$x(t) = v^*(t)\cdot e^{j\varphi(t)}$$

$$(7)$$

Die Frequenz des Drehzeigers steigt gemäß

$$f(t) = \frac{1}{K}\cdot B_{res}^2\cdot t$$

$$(8)$$

linear mit der Zeit an. Der *K-Faktor* gibt an, wie schnell gesweept wird. Da das Resolution-Filter näherungsweise eine Einschwingzeit von $T_{res}$ benötigt, sollte die Frequenz innerhalb $T_{res}$ maximal um $B_{res}$ verändert werden, was nach Gleichung (8) einem maximalen K -Faktor von K = 1 entspricht. Durch Integration ergibt sich die Phase

$$\varphi(t) = \int_{-\infty}^{t} 2\pi f(t)\, dt = \frac{\pi}{K} \cdot B_{res}^2 \cdot t^2$$

$$(9)$$

Das Signal $x(t)$ wird anschließend durch das Resolution-Filter mit der Impulsantwort $h_{used}(t)$ gefiltert und es entsteht das Ausgangssignal $y(t)$. Von diesem Ausgangssignal wird die Einhüllende $|y(t)|$ bestimmt und anschließend i.a. logarithmisch auf dem Spektrum-Analyzer dargestellt.

Das Ausgangssignal ergibt sich durch

$$y(t) = x(t) * h_{used}(t) = \int_{-\infty}^{\infty} h_{used}(\tau) \cdot x(t - \tau)\, d\tau$$

Durch Einsetzen von Gleichung (7) erhält man

$$y(t) = \int_{-\infty}^{\infty} h_{used}(\tau) \cdot v^*(t - \tau)\, e^{j\varphi(t-\tau)}\, d\tau$$

Durch Einsetzen von Gleichung (9) ergibt sich schließlich

$$y(t) = \int_{-\infty}^{\infty} h_{used}(\tau) \cdot v^*(t - \tau)\, e^{j\frac{\pi}{K}\cdot B_{res}^2 \cdot (t-\tau)^2}\, d\tau$$

Durch Ausmultiplikation erhält man

$$y(t) = \underbrace{e^{j\frac{\pi}{K}\cdot B_{res}^2 \cdot t^2}}_{e^{j\varphi(t)}} \int_{-\infty}^{\infty} \underbrace{h_{used}(\tau)\, e^{j\frac{\pi}{K}\cdot B_{res}^2 \cdot \tau^2}}_{h_{disp}(\tau)} \cdot v^*(t - \tau)\, e^{-j\frac{2\pi}{K}\cdot B_{res}^2 \cdot t\tau}\, d\tau$$

$$(10)$$

wobei der erste Term $e^{j\varphi(t)}$ nicht stört, weil letztendlich $|y(t)|$ zur Anzeige gebracht wird. In der Formel wird die Impulsantwort

$$h_{disp}(t) = h_{used}(t) \cdot e^{j\frac{\pi}{K}B_{res}^2 t^2}$$

(11)

eingeführt. Der Index "disp" steht für "displayed", weil nachfolgend gezeigt wird, daß das Spektrum dieser Impulsantwort zur Anzeige kommt.

Nach Gleichung (8) ergibt sich durch Umformung

$$t = \frac{f(t) \cdot K}{B_{res}^2}$$

(12)

Durch Einsetzen in Gleichung (10) ergibt sich

$$y(t) = e^{j\varphi(t)} \int_{-\infty}^{\infty} h_{disp}(\tau) \cdot v^*(t-\tau) e^{-j\omega(t)\cdot\tau} d\tau$$

(13)

Nun können einige interessante Aussagen festgehalten werden: Der Vergleich von Gleichung (13) mit der Fourieranalyse in Gleichung (1) zeigt, daß

1. bei der Spektrumanalyse nicht das verwendete Resolution-Filter $h_{used}(t)$, sondern das nach Gleichung (11) beschriebene "displayed" Resolution-Filter $h_{disp}(t)$ zur Anzeige kommt. Bei langsamen Sweep für ungefähr $K \geq 2$ stimmen $h_{used}(t)$ und $h_{disp}(t)$ näherungsweise überein. Bei schnellem Sweep hingegen treten deutliche Unterschiede auf. In diesem Fall bricht der Pegel ein und das dargestellte Resolution-Filter wird breiter (das Filter kann nicht mehr einschwingen).

2. In Gleichung (13) wird im Gegensatz zur Fourieranalyse nicht $v(\tau)$, sondern das um $t$ verschobene Zeitsignal verwendet. Folglich wertet der Spektrumanalyzer ein zeitlich gleitendes Beobachtungsintervall aus, was nicht weiter störend ist. Bemerkenswert ist die Frage, welchen Einfluß die Geschwindigkeit des gleitenden Beobachtungsfensters auf das Ausgangsspektrum hat.

Um die Frage des gleitenden Beobachtungsfensters in 2. besser beurteilen zu können, empfiehlt es sich, das Parseval'sche Theorem gemäß

$$\int_{-\infty}^{\infty} x_1(\tau) \cdot x_2^*(\tau) d\tau = \int_{-\infty}^{\infty} X_1(F) \cdot X_2^*(F) dF$$

auf Gleichung (13) anzuwenden. Durch Substitution von

$$x_1(\tau) = h_{disp}(\tau) \cdot e^{-j\omega(t)\tau} \quad \overset{\tau}{\rightarrow} \quad X_1(F) = H_{disp}\big(F + f(t)\big)$$

$$x_2(\tau) = v(t - \tau) \quad \overset{\tau}{\rightarrow} \quad X_2(F) = V(-F) \cdot e^{j2\pi F t}$$

läßt sich Gleichung (13) durch

$$y(t) = e^{j\varphi(t)} \int_{-\infty}^{\infty} H_{disp}\big(F + f(t)\big) \cdot V^*(-F) e^{-j2\pi F t} dF$$

$$= e^{j\varphi(t)} \int_{-\infty}^{\infty} H_{disp}\big(F - f(t)\big) \cdot V^*(F) e^{-j2\pi F t} dF$$

$$(14)$$

beschreiben. Damit erhält man erwartungsgemäß eine Faltung des Eingangsspektrums mit dem Resolution-Filter gemäß

$$y(t) = e^{j\varphi(t)} \quad H_{disp}\big(f(t)\big) * \left[ V^*\big(f(t)\big) e^{-j2\pi f(t)t} \right]$$

Durch Einsetzen von Gleichung (12) in Gleichung (14) ergibt sich schließlich

$$y(t) = e^{j\varphi(t)} \int_{-\infty}^{\infty} H_{disp}\big(F - f(t)\big) \cdot V^*(F) e^{-j\frac{2\pi K}{B_{res}^2} F f(t)} dF$$

$$(15)$$

In der DE 101 05 258 A1 ist nur ein sweepoptimiertes Gaußfilter hergeleitet. Dieses sweepoptimierte Gaußfilter muß linearphasig sein.

Neue Betrachtungen haben gezeigt, daß das sweepoptimierte Filter für ein beliebiges Filter hergeleitet werden kann. Das vorgegebene Filter darf sowohl in Betrag und auch in der Phase beliebig sein. Besonders interessant ist die Tatsache, daß keine Restriktionen an die Phase gestellt werden. Bei dem aus der DE 101 05 258 A1 bekannten Sweepfilter ist dieser Freiheitsgrad nicht nutzbar, weil dort die Linearphasigkeit gefordert wurde. Durch die beliebig vorgebbare Phase können nun erfindungsgemäß minimalphasige Filter realisiert werden, welche optimal hinsichtlich der notwendigen Einschwingzeit sind.

In Gleichung (10) wird die "displayed" Impulsantwort $h_{disp}(t)$ und die "used" Impulsantwort $h_{used}(t)$ definiert. Hierbei beschreibt die Impulsantwort $h_{disp}(t)$ die Transformierte des im Sweep dargestellten Frequenzgangs $H_{disp}(f)$ des Resolution-Filters, während die Impulsantwort $h_{used}(t)$ die Transformierte des verwendeten Filters mit dem Frequenzgang

$H_{used}(f)$ ist. Aus Gleichung (11) ist der Zusammenhang zwischen den beiden Impulsantworten gemäß

$$h_{disp}(t) = h_{used}(t) \cdot e^{j \frac{\pi}{K} B_{res}^2 t^2}$$

bekannt. Die erfindungsgemäße Vorgehensweise besteht nun darin, nicht den Frequenzgang $H_{used}(f)$ des verwendeten Filters, sondern den Frequenzgang des dargestellten Filters $H_{disp}(f)$ zu entwickeln. Da bei der Spektrumanalyse nur der Betragsfrequenzgang dargestellt wird, darf somit die Phase beliebig gewählt werden. Nach dem Design wird durch Rücktransformation die Impulsantwort $h_{disp}(t)$ berechnet. Im nächsten Schritt wird nach obiger Formel die gesuchte Impulsantwort $h_{used}(t)$ des sweepoptimierten Filters bei der Sweepgeschwindigkeit $K$ berechnet.

Nachfolgend wird ausführlicher auf die einzelnen Design-Schritte eingegangen:

1. Vorgabe des gewünschten dargestellten Betragsfrequenzgangs $|H_{disp}(f)|$:

Häufig wird das Gaußfilter verwendet. Von Interesse können aber auch Filter mit weniger steil abfallendem Betragsfrequenzgang sein, weil damit eine geringere Gruppenlaufzeitverzögerung erzielt wird. Damit geht eine kürzere Einschwingzeit einher, was besonders bei Applikationen mit häufigen Einschwingvorgängen des Filters wünschenswert ist.

2. Vorgabe der Phase von $H_{disp}(f)$:

Prinzipiell kann die Phase beliebig vorgegeben werden. Im Sinne einer minimalen Gruppenlaufzeitverzögerung empfiehlt es sich, ein minimalphasiges Filter zu verwenden. Nachfolgend wird auf das Design eingegangen. Hierbei wird vorausgesetzt, dass das Filter digital realisiert wird, d.h. es wird die diskrete Impulsantwort $h_{disp}(k)$ mit $k = [0, nof_{Taps}-1]$ berechnet, wobei $nof_{Taps}$ die Anzahl der Taps beschreibt.

Am einfachsten ist der Entwurf eines linearphasigen Filters der Länge $nof_{Taps}$ mit dem vorgegebenen Betragsfrequenzgang $|H_{disp}(f)|$. Gängige Verfahren sind der Remez- oder der MMS-Algorithmus. Anschließend werden die Nullstellen der Übertragungsfunktion in der komplexen z-Ebene bestimmt. Die Nullstellen außerhalb des Einheitskreises werden anschließend in den Einheitskreis gespiegelt, wodurch der Betragsfrequenzgang nicht verändert wird. Dieses Verfahren ist suboptimal, weil dadurch immer minimalphasige Filter mit doppelten Nullstellen entstehen, was zu einer Einschränkung des Freiheitsgrades führt.

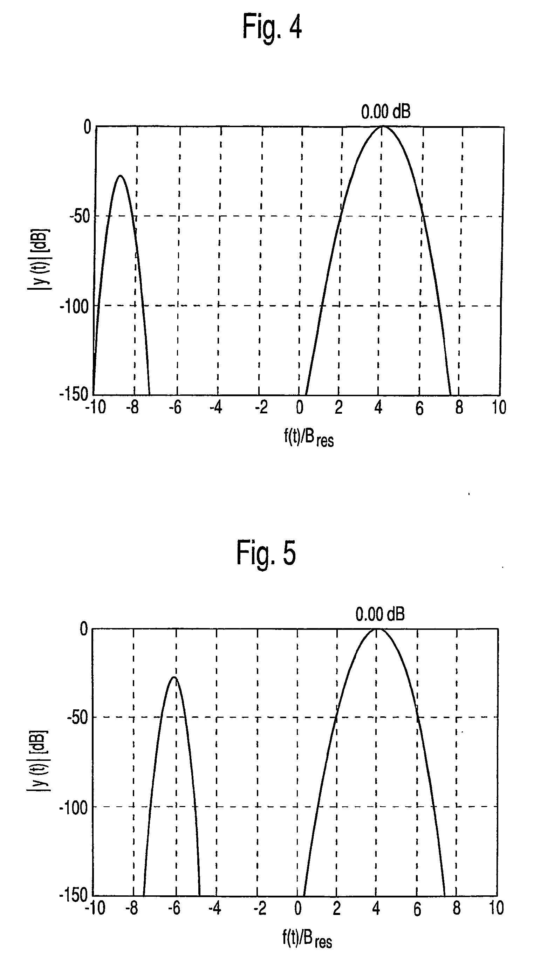

In Fig. 3 wird ein Beispiel der diskreten Impulsantwort $h(k)$ als Funktion des Abtastindex eines minimalphasiges Gaußfilters im Vergleich zu einem linearphasigen Gaußfilter gezeigt. Man erkennt, daß das minimalphasige Filter eine wesentlich kürzere Gruppenlaufzeitverzögerung als das linearphasige Filter besitzt. Natürlich besitzt das minimalphasige Filter die gleiche Tapzahl $nof_{Taps} = 161$ wie das linearphasige Filter, d.h. die Einschwingzeit ist gleich lang. Allerdings klingt beim Sweep der Einschwingfehler des minimalphasigen Filters wesentlich schneller ab als beim linearphasigen Filter ab, was ein Vergleich von Fig. 4 mit Fig. 5 verdeutlicht. Fig. 4 zeigt den Sweep mit einem minimalphasigen Filter, während Fig. 5 den gleichen Sweep mit einem linearphasigen Filter zeigt. Das Eingangssignal ist jeweils eine diskrete Spektrallinie. Man erkennt, daß beim minimalphasigen Filter der Fehler bereits während der Einschwingphase, d.h. unmittelbar nach der "ersten Keule", so stark abgeklungen ist, dass bereits ungefähr die zweite Hälfte der Einschwingphase für die Analyse genutzt werden kann. Beim linearphasigen Filter hingegen kann die Analyse erst später begonnen werden.

Mit dem nachfolgenden Verfahren wird ein besseres Filterdesign erreicht. Man entwirft das linearphasige Filter nicht mit $nof_{Taps}$ Taps, sondern mit der doppelten Länge $2 \cdot nof_{Taps}$. Als Zielfunktion gibt man ebenfalls nicht $|H_{disp}(f)|$, sondern $|H_{disp}(f)|^2$ vor. Gleiches gilt für eventuell verwendete Kostenfunktionen. Anschließend werden von dem ermittelten Digitalfilter $h_{disp}^{(long)}(k)$ die Nullstellen im Einheitskreis berechnet. Die spiegelsymmetrischen Nullstellen außerhalb des Einheitskreises werden verworfen. Die so erzeugte Impulsantwort $h_{disp}(k)$ besitzt die gewünschte Tapzahl $nof_{Taps}$. Weiterhin besitzt es den gewünschten Ziel-Betragsfrequenzgang $|H_{disp}(f)|$. Das so berechnete Filter hat keine doppelten Nullstellen, womit dieses Design den vollen Freiheitsgrad ausnutzt.

3. Berechnung von $h_{used}(k)$:

Nun liegt die Impulsantwort $h_{disp}(k)$ vor. Nach Gleichung (11) wird die Impulsantwort des zu verwendenden Filters gemäß

$$h_{used}(k) = h_{disp}(k) \cdot e^{-j\frac{\pi}{K}B_{res}^2(k-k_o)^2 \cdot T_a^2} \quad \text{mit} \quad k = [0, nof_{Taps}-1]$$

$$(16)$$

berechnet, wobei $T_a$ die Abtastperiode des Digitalfilters ist. Im Unterschied zu Gleichung (11) wurde der Parameter $k_o$ eingeführt, welcher im Spektralbereich eine Verschiebung des Spektrums bewirkt. Durch den Parameter $k_0$ können verschiedene wünschenswerte Effekte erreicht werden:

1. Kompensation des Frequenznachlaufs: Durch die Gruppenlaufzeit des Resolution-Filters ist die korrespondierende Frequenz vom Ausgangssignal ebenso nachlaufend. Durch Einstellung eines entsprechenden $k_o$ wird dieser Effekte erfindungsgemäß kompensiert werden.
2. Minimierung der benötigten Bandbreite von $H_{used}(f)$ : Mit zunehmender Sweepgeschwindigkeit (kleineres $K$) liegt die Mitte des Spektrums $H_{used}(f)$ nicht mehr im Frequenz-Ursprung $f = 0$, sondern verschiebt sich hin zu größeren Frequenzen. Bei dem vorliegenden digitalen System müßte damit die benötigte Abtastrate $f_a$ unnötig erhöht werden, um weiterhin das Abtasttheorem zu erfüllen. Durch entsprechende Wahl von $K_0$ läßt sich dieser Effekt vermeiden. In guter Näherung sollte $k_0 = k_{max}$ gewählt werden, wobei $k_{max}$ der Zeitpunkt des Maximums von $|h_{disp}(k)|$ ist.

Weiterhin sei auf eine für die Implementierung sinnvolle Vorgehensweise hingewiesen: Grundsätzlich sollte nicht $h_{used}(k)$ für verschiedene Sweepgeschwindigkeiten $K$ vorberechnet und im Gerät abgelegt werden, sondern lediglich $h_{disp}(k)$ vorberechnet werden. Nach Kenntnis der gewünschten Sweepgeschwindigkeit wird im Gerät die interessierende Impulsantwort $h_{used}(k)$ nach der Vorschrift in Gleichung (16) berechnet. Dieses Verfahren besitzt den Vorteil, daß der Verwaltungs- und Speicheraufwand der einzelnen Impulsantworten wegfällt. Weiterhin wird immer die Impulsantwort für das vorliegende $K$ verwendet. Damit tritt kein Quantisierungsfehler auf, weil die Impulsantwort $h_{used}(k)$ nicht für genau den eingestellten $K$-Faktor verfügbar ist.
Die geschlossene Darstellung der Impulsantwort des komplexen Auflösungsfilters wird nachfolgend bestimmt. Zur Herleitung der geschlossenen Darstellung der Impulsantwort $h_{used}$ des Filters wird zunächst der zeitkontinuierliche Fall betrachtet. Der freie Variationsparameter ist dann $t_0 = k_0 \cdot T_a$.
Zur Spektrumanalyse wird ein gaußförmiges Resolution-Filter mit der Bandbreite $B_{res}$ verwendet. Das "displayed" Resolution-Filter soll die Impulsantwort und Übertragungsfunktion

$$h_{disp}(t) = \sqrt{\frac{\pi}{2\ln(2)}} B_{res} \cdot e^{-\frac{\pi^2}{2\ln(2)} \cdot \left(\frac{t}{T_{res}}\right)^2} \quad * \quad h_{allp}(t)$$

$$H_{disp}(f) = e^{-2\ln(2) \cdot \left(\frac{f}{B_{res}}\right)^2} \cdot e^{j\varphi(f)}$$

$$(17)$$

besitzen. Durch $|H_{disp}(f=0)| = 1$ wird die amplitudenrichtige Darstellung der Spektrallinien sichergestellt. Der Phasenverlauf $\varphi(f)$ der Übertragungsfunktion kann beliebig gewählt werden, weil bei der Spektrumanalyse $|H_{disp}(f)|$ dargestellt wird. Der Phasengang $\varphi(f)$ kann beispielsweise nach dem vorne beschrieben Verfahren bestimmt werden, damit die Übertragungsfunktion minimalphasig wird, was zu einem schnellen Einschwingen von $h_{disp}(t)$ führt. Die Fourier-Rücktransformierte von $e^{j\varphi(f)}$ ist $h_{allp}(t)$. Da im Frequenzbereich eine Multiplikation mit $e^{j\varphi(f)}$ durchgeführt wird, muss im Zeitbereich entsprechend eine Faltung mit der Impulsantwort $h_{allp}(t)$ eines Allpasses durchgeführt werden, was durch das Zeichen * symbolisiert wird. Aufgrund des in Gleichung (11) angegebenen Zusammenhangs zwischen $h_{disp}(t)$ und $h_{uses}(t)$ beschreibt $\varphi(t)$ nicht nur den Phasengang der Übertragungsfunktion $H_{disp}(f)$, sondern auch den Phasengang der Übertragungsfunktion $H_{used}(f)$ des Resolutions-Filters.
Die Impulsantwort des zu verwendenden Resolution-Filter erhält man nach Gleichung (16) in zeitkontinuierlicher Darstellung zu

$$h_{used}(t) = h_{disp}(t) \cdot e^{-j\frac{\pi}{K}B_{res}^2(t-t_0)^2}$$

$$(18)$$

Durch Einsetzen ergibt sich

$$h_{used}(t) = \sqrt{\frac{\pi}{2\ln(2)}} \, B_{res} \cdot \left[ e^{-\frac{\pi^2}{2\ln(2)}\left(\frac{t}{T_{res}}\right)^2} * h_{allp}(t) \right] \cdot e^{-j\frac{\pi}{K}B_{res}^2(t-t_0)^2}$$

$$(19)$$

Der Übergang zur diskreten Impulsantwort folgt aus

$$h_{used}(k) = T_a \, h_{used}(t{=}kT_a) \, .$$

Durch Einsetzen von Gleichung (19) erhält man

$$h_{used}(k) = \sqrt{\frac{\pi}{2\ln(2)}} \cdot B_{res} \cdot T_a \cdot \left[ e^{-\frac{\pi^2}{2\ln(2)}\left(\frac{t}{T_{res}}\right)^2} * h_{allp}(t) \right] \cdot e^{-j\frac{\pi}{K}B_{res}^2(t-t_0)^2}$$

$$(20)$$

mit $T_{res} = I/B_{res}$, $B_{res}$ = Resolution-Bandbreite (AuflösungsBandbreite) bei 3dB Signalabfall gegenüber dem Maximum und $T_a$ = Abtastperiode im Basisband.

Dabei ergibt sich folgende allgemeine Darstellung für die Impulsantwort:

$$h_{used}(k) = C_1 \cdot \left[ e^{-C_2 T_a^2 \cdot k^2} * h_{allp}(t) \right] \cdot e^{-jC_3(k-k_0)^2 \cdot T_a^2}$$

Hierin bedeuten $k$ der Abtastindex und $T_a$ die Abtastperiode. $C_1$, $C_2$ und $C_3$ sind Konstanten, wobei die Konstante $C_1$ vorzugsweise

$$C_1 = \sqrt{\frac{\pi}{2\ln(2)} \cdot B_{res} \cdot T_a}$$

beträgt und wobei $B_{res}$ die Bandbreite des Auflösungsfilters ist.

Die Konstante $C_2$ beträgt vorzugsweise

$$C_2 = \frac{\pi^2}{2\ln(2)} \cdot \frac{1}{T_{res}^2} \, ,$$

wobei $T_{res} = 1/B_{res}$ die Reziprokbandbreite $B_{res}$ des Auflösungsfilters ist.

Die Konstante $C_3$ beträgt vorzugsweise

$$C_3 = \frac{\pi}{K} \cdot B_{res}^2 \, ,$$

wobei $B_{res}$ die Bandbreite des Auflösungsfilters und $K$ der $K$-Faktor des Auflösungsfilters ist, der über die Gleichung

$$f(t) = \frac{1}{K} \cdot B_{res}^2 \cdot t$$

definiert ist und f(t) eine linear mit der Zeit t variable Frequenz ist, die dem dem Auflösungsfilter 4 vorgeschalteten Mischer 3 des Spekrumanalysators zugeführt wird.

Es ist jedoch auch denkbar, die Konstanten $C_1$, $C_2$ und $C_3$ in anderer Weise im Rahmen der vorliegenden Erfindung festzulegen.

**Patentansprüche**

1. Auflösungsfilter (4) für einen Spekrumanalysator (1),
   wobei das Auflösungsfilter (4) folgende komplexe, diskrete Impulsantwort $h_{used}(k)$ hat:

$$h_{used}(k) = C_1 \cdot \left[ e^{-C_2 T_a^2 \cdot k^2} * h_{allp}(t) \right] \cdot e^{-jC_3(k-k_0)^2 \cdot T_a^2}$$

wobei $C_1$, $C_2$ und $C_3$ Konstanten, k der Abtastindex und $T_a$ die Abtastperiode des Auflösungsfilters sind,
   wobei $h_{allp}(t)$ die Fourier-Rücktransformierte von $e^{j\varphi(f)}$ ist, worin $\varphi(f)$ ein beliebig vorgegebener Phasengang in Abhängigkeit von der Frequenz in der Übertragungsfunktion des Auflösungsfilters ist,
   wobei $k_0$ ein freier Variationsparameter ist und
   wobei der Variationsparameter $k_0$ so eingestellt ist, daß der durch die Gruppenlaufzeit des Auflösungsfilters (4) bedingte Frequenznachlauf kompensiert ist.

**2.** Auflösungsfilter nach Anspruch 1,
**dadurch gekennzeichnet,**
**daß** der Variationsparameter $k_o$ so eingestellt ist, daß die Mitte des Frequenzgangs $H_{used}(f)$ des Auflösungsfilters im Frequenz-Ursprung bei der Frequenz $f = 0$ liegt.

**3.** Auflösungsfilter nach einem der Ansprüche 1 oder 2,
**dadurch gekennzeichnet,**
**daß** $\varphi(f)$ und somit $h_{allp}(t)$ so gewählt sind, daß sich ein minimalphasiges Auflösungsfilter ergibt.

**4.** Auflösungsfilter (4) nach einem der Ansprüche 1 bis 3,
**dadurch gekennzeichnet,**
**daß** die Konstante $C_1$

$$C_1 \;=\; \sqrt{\frac{\pi}{2\ln(2)}} \cdot B_{res} \cdot T_a$$

beträgt, wobei $B_{res}$ die Bandbreite des Auflösungsfilters (4) ist.

**5.** Auflösungsfilter (4) nach einem der Ansprüche 1 bis 4,
**dadurch gekennzeichnet,**
**daß** die Konstante $C_2$

$$C_2 \;=\; \frac{\pi^2}{2\ln(2)} \cdot \frac{1}{T_{res}^{\,2}}$$

beträgt, wobei $T_{res} = 1/B_{res}$ die reziproke Bandbreite des Auflösungsfilters (4) ist.

**6.** Auflösungsfilter (4) nach einem der Ansprüche 1 bis 5,
**dadurch gekennzeichnet,**
**daß** die Konstante $C_3$

$$C_3 \;=\; \frac{\pi}{K} \cdot B_{res}^{\,2}$$

beträgt, wobei $B_{res}$ die Bandbreite des Auflösungsfilters (4) und K der K-Faktor des Auflösungsfilters (4) ist, wobei der K-Faktor über die Gleichung

$$f(t) = \frac{1}{K} \cdot B_{res}^{\,2} \cdot t$$

definiert ist und f(t) eine linear mit der Zeit t variable Frequenz ist, die einem dem Auflösungsfilter (4) vorgeschalteten Mischer (3) des Spekrumanalysators (1) zugeführt wird.

**7.** Spektrumanalysator zur Analyse des Spektrums eines Eingangssignals mit einem die Frequenzauflösung festlegenden Auflösungsfilter (4) nach einem der Ansprüche 1 bis 6.

**Claims**

1. Resolution filter (4) for a spectrum analyser (1),
   wherein the resolution filter (4) has the following complex, discrete impulse response $h_{used}(k)$:

$$h_{used}(k) = C_1 \cdot \left[ e^{-C_2 T_a^2 \cdot k^2} * h_{allp}(t) \right] \cdot e^{-jC_3 (k-k_0)^2 \cdot T_a^2}$$

   wherein $C_1$, $C_2$ and $C_3$ are constants, k is the sampling index and $T_a$ is the sampling period of the resolution filter,
   wherein $h_{allp}(t)$ is the Fourier retransform of $e^{j\varphi(f)}$, in which $\varphi(f)$ is a randomly-specified phase response dependent upon the frequency of the transmission function of the resolution filter,
   wherein $k_0$ is a free variation parameter and
   wherein the variation parameter $k_0$ is set in such a manner that the frequency overshoot determined by the group delay of the resolution filter (4) is compensated.

2. Resolution filter according to claim 1,
   **characterised in that**
   the variation parameter $k_0$ is set in such a manner that the middle of the frequency response $H_{used}(f)$ of the resolution filter is disposed at the frequency origin at the frequency f=0.

3. Resolution filter according to any one of claims 1 or 2,
   **characterised in that**
   $\varphi(f)$ and therefore also $h_{allp}(t)$ are selected in such a manner that a minimal-phase resolution filter is formed.

4. Resolution filter (4) according to any one of claims 1 to 3,
   **characterised in that**
   the value of the constant $C_1$ is:

$$C_1 = \sqrt{\frac{\pi}{2\ln(2)}} \cdot B_{res} \cdot T_a$$

   wherein $B_{res}$ is the bandwidth of the resolution filter (4).

5. Resolution filter (4) according to any one of claims 1 to 4,
   **characterised in that**
   the value of the constant $C_2$ is

$$C_2 = \frac{\pi^2}{2\ln(2)} \cdot \frac{1}{T_{res}^2}$$

   wherein $T_{res} = 1/B_{res}$ is the reciprocal bandwidth of the resolution filter (4).

6. Resolution filter (4) according to any one of claims 1 to 5,
   **characterised in that**
   the value of the constant $C_3$ is

$$C_3 = \frac{\pi}{K} \cdot B_{res}^2$$

wherein $B_{res}$ is the bandwidth of the resolution filter (4) and K is the K-factor of the resolution filter (4), wherein the K-factor is defined via the equation:

$$f(t) = \frac{1}{K} \cdot B_{res}^2 \cdot t$$

and f(t) is a frequency variable with time t in a linear manner, which is supplied to a mixer (3) of the spectrum analyser (1) connected upstream of the resolution filter (4).

7. Spectrum analyser for analysing the spectrum of an input signal with a resolution filter (4) specifying the frequency resolution according to any one of claims 1 to 6.

**Revendications**

1. Filtre de résolution (4) pour un analyseur de spectre (1),
le filtre de résolution (4) ayant la réponse impulsionnelle complexe discrète $h_{used}$ (k) suivante :

$$h_{used}(k) = C_1 \cdot \left[ e^{-C_2 T_o^2 \cdot k^2} * h_{allp}(t) \right] \cdot e^{-j C_3 (k-k_0)^2 \cdot T_o^2}$$

$C_1$, $C_2$ et $C_3$ étant des constantes, k étant l'index d'exploration et $T_0$ étant la période d'exploration du filtre de résolution,
$h_{allp}$ (t) étant la transformée de Fourier inverse de $e^{j*(f)}$, où *(f) est une courbe de phase quelconque imposée selon la fréquence dans la fonction de transmission du filtre de résolution,
$k_0$ étant un paramètre de variation libre et
le paramètre de variation $k_0$ étant réglé de telle façon que la poursuite de la fréquence résultant du temps de propagation de groupe du filtre de résolution (4) soit compensée.

2. Filtre de résolution selon la revendication 1,
   **caractérisé en ce que**
   le paramètre de variation $k_0$ est réglé de telle façon que le milieu de la courbe de fréquence $H_{used}$ (f) du filtre de résolution se situe à l'origine de la fréquence à la fréquence *f* = 0.

3. Filtre de résolution selon l'une quelconque des revendications 1 ou 2,
   **caractérisé en ce que**
   *(f), et de ce fait $h_{allp}$ (t), sont sélectionnés de telle façon qu'un filtre de résolution à phase minimale soit obtenu.

4. Filtre de résolution (4) selon l'une quelconque des revendications 1 à 3,
   **caractérisé en ce que**
   la constante $C_1$ est :

$$C_1 = \sqrt{\frac{\pi}{2\ln(2)}} \cdot B_{res} \cdot T_s$$

où $B_{rcs}$ est la largeur de bande du filtre de résolution (4).

5. Filtre de résolution (4) selon l'une quelconque des revendications 1 à 4,
   **caractérisé en ce que**
   la constante $C_2$ est :

$$C_2 = \frac{\pi^2}{2\ln(2)} \cdot \frac{1}{T_{res}^2}$$

où $T_{res} = 1/B_{res}$ est la largeur de bande réciproque du filtre de résolution (4).

6. Filtre de résolution (4) selon l'une quelconque des revendications 1 à 5,
   **caractérisé en ce que**
   la constante $C_3$ est :

$$C_3 = \frac{\pi}{K} \cdot B_{res}^2$$

où $B_{res}$ est la largeur de bande du filtre de résolution (4) et K est le facteur K du filtre de résolution (4), le facteur K étant défini par l'équation :

$$f(t) = \frac{1}{K} \cdot B_{res}^2 \cdot t$$

et $f(t)$ étant une fréquence linéaire variable dans le temps t qui est amenée à un mélangeur (3) de l'analyseur de spectre (1) placé devant le filtre de résolution (4).

7. Analyseur de spectre pour l'analyse du spectre d'un signal d'entrée avec un filtre de résolution (4) qui définit la résolution de la fréquence, selon l'une quelconque des revendications 1 à 6.

Fig. 1

Bandpass 21

A / D 22

ZF 26 Q-Mischung

NCO 25

ZF 27 I-Mischung

Q-Mischung 23 IQ-Mischung

cos sin

24

29

Sweep Filter 28

Hüllkurven-Gleichrichter 31

$\sqrt{I^2+Q^2}$ 32

Logarith-mierer 33

Lin / Log 34

Video-Filter 35

36

Detektoren 37

Peak 38

Auto Peak 39

Sample 40

RMS 41

Prozessor 42

20

ZF

17

## Fig. 2

Res-Filter 4

## Fig. 3

## Fig. 4

## Fig. 5